# EUROPEAN PATENT SPECIFICATION

(11) **EP 4 379 106 B1**
(45) Date of publication and mention of the grant of the patent: **01.10.2025**
(21) Application number: 23212505.4
(22) Date of filing: 28.11.2023
(51) Int. Cl.: D05B 19/00, D05B 69/00, H02P 8/00

(54) **SEWING MACHINE AND MANAGEMENT SYSTEM FOR SEWING MACHINE**
NÄHMASCHINE UND VERWALTUNGSSYSTEM FÜR NÄHMASCHINE
MACHINE À COUDRE ET SYSTÈME DE GESTION POUR MACHINE À COUDRE

(30) Priority: 29.11.2022 JP 2022190606
(43) Date of publication of application: 05.06.2024
(73) Proprietor: JUKI Corporation, Tama-shi, Tokyo 206-8551 (JP)
(72) Inventor: Ishihara, Kazuyuki, Tokyo, 206-8551 (JP)
(74) Representative: Kutzenberger Wolff & Partner

(56) References cited:
- DE-A1- 4 134 883
- US-A1- 2017 275 799
- US-A1- 2019 003 094

## Description

### FIELD

The present application relates to a sewing machine and a management system for a sewing machine.

### BACKGROUND

A stepping motor, known as an electric motor that can accurately locate an angle of a rotary shaft, has been widely used in a sewing machine in recent years. Japanese Patent Application Publication No. 2009095148 discloses a drive device for a stepping motor of a sewing machine that controls ON/OFF of a switching element in a way that a current flowing from the coil flows back to the coil itself due to self-induction of the coil when the stepping motor is in a stopped state.

US2017275799A discloses a sewing machine according to the preamble of claim 1 with a closed-loop control device including an isolated switch-mode power supply module, a DC motor, a speed control module, a processor, an electronic switch, a current detection module and a voltage detection module. The isolated switch-mode power supply module rectifies an AC power to a DC power and supplies the DC power to the DC motor. The speed control module sends a speed signal to the processor. The processor adjusts an output voltage to the DC motor according to the speed signal. The current detection module and the voltage detection module further detect an operating current signal and an operating voltage signal of the DC motor for the processor to control a turn-on time of the electronic switch to adjust an average operating voltage of the DC motor according to the operating current signal, the operating voltage signal and the speed signal.

DE4134883A1 discloses a sewing device for easily and simply distinguishing or selecting among a plurality of sewing machines or motors for the purpose of controlling them.

US20190003094A1 discloses a production management system including a sewing machine and a production management device. The sewing machine records chronological operation data. The production management device communicates with the sewing machine, and acquires and stores the operation data. The sewing machine includes a time acquisition unit that acquires a time at the time of the communication from a clock of the production management device at the time of the communication with the production management device and grants time information based on the time at the time of the communication to the operation data recorded at the time of the communication.

### SUMMARY

### Problem to be solved

Activities for the Sustainable Development Goals (SDGs) are becoming more active, and traditional sewing machines have room for improvement in reducing power consumption.

Embodiments of the present application aim to suppress an increase in the cost of a sewing machine and control power consumption.

### Solutions

The invention is set out in the appended set of claims.

### Beneficial effects

According to the embodiments of the present application, it is possible to suppress an increase in the cost of a sewing machine and control power consumption.

### BRIEF DESCRIPTION OF DRAWINGS

FIG. 1 is a perspective view showing a sewing machine according to an embodiment;
FIG. 2 is a perspective view showing a part of a sewing machine according to an embodiment;
FIG. 3 is a perspective view showing a part of the sewing machine according to an embodiment;
FIG. 4 is a block diagram showing an example of a functional structure of a sewing machine according to an embodiment;
FIG. 5 is a flowchart showing an example of a processing procedure of a sewing machine;
FIG. 6 is a structural diagram of a management system for a sewing machine;
FIG. 7 is a diagram showing an example of a structure of a management device;
FIG. 8 is a diagram showing an example of operating of a sewing machine and a management device; and
FIG. 9 is a diagram for illustrating a functional structure of a sewing machine according to the invention.

### Reference numerals:

1: sewing machine; 2: table; 3: frame; 4: head; 5: head rotary device; 6: holding member; 7: holding member moving device; 7X: X-axis moving device; 7Y: Y-axis moving device; 8: shuttle; 9: shuttle rotary device; 10: power switch; 11: start switch; 12: pause switch; 13: emergency stop switch; 14: operation panel; 16: thread winding device; 17: thread stand device; 18: input device; 19: display device; 110: control portion; 111: calculation portion; 112: provision portion; 120: storage portion; 121: program; 122: sewing machine information; 123: measurement information; 124: power consumption information; 130: communication portion; 150: power portion; 150L: power supply line; 151: power supply circuit; 152: measurement circuit; 170: functional portion; 180: supply line; 190: second measurement circuit; 400: management device; 410: display portion; 420: operation portion; 430: communication portion; 440: storage portion; 441: program; 442: management information; 450: control portion; 500: management system for sewing machine; 1000: power supply.

### DETAILED DESCRIPTION OF THE EMBODIMENTS

Hereinafter, embodiments according to the present disclosure will be described with reference to the drawings, but the present disclosure is not limited to the embodiments. Structural elements of the embodiments described below can be combined as appropriate. Furthermore, some structural elements may not be used.

A local coordinate system is defined for a sewing machine 1. In the embodiment, the local coordinate system defined in the sewing machine 1 is appropriately referred to as a sewing machine coordinate system. The sewing machine coordinate system is defined by an XYZ orthogonal coordinate system. In the embodiment, a positional relationship of each part will be explained based on the sewing machine coordinate system. A direction parallel to an X-axis within a predetermined plane is defined as an X-axis direction. A direction parallel to a Y-axis within the predetermined plane perpendicular to the X-axis is defined as a Y-axis direction. A direction parallel to a Z-axis perpendicular to the predetermined plane is defined as the Z-axis direction. A direction of rotation or inclination centered on the X axis is defined as a θX direction. A direction of rotation or inclination centered on the Y-axis is defined as a θY direction. A direction of rotation or inclination centered on the Z-axis is defined as a θZ direction. Further, in the embodiment, a plane including the X axis and the Y axis is appropriately referred to as an XY plane. The XY plane is parallel to the predetermined plane. In the embodiment, it is assumed that the XY plane is parallel to a horizontal plane. The Z-axis direction is an upward-downward direction. The +Z direction is an upward direction, and the -Z direction is a downward direction. In addition, the XY plane may be inclined with respect to the horizontal plane.

### Sewing Machine

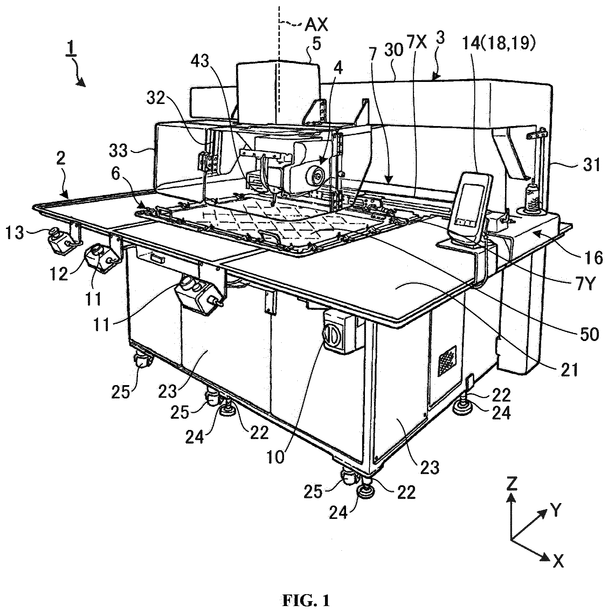

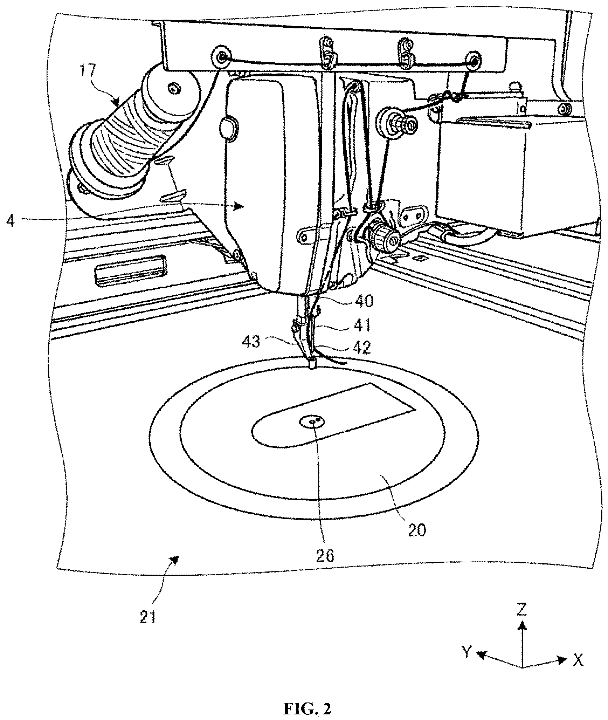

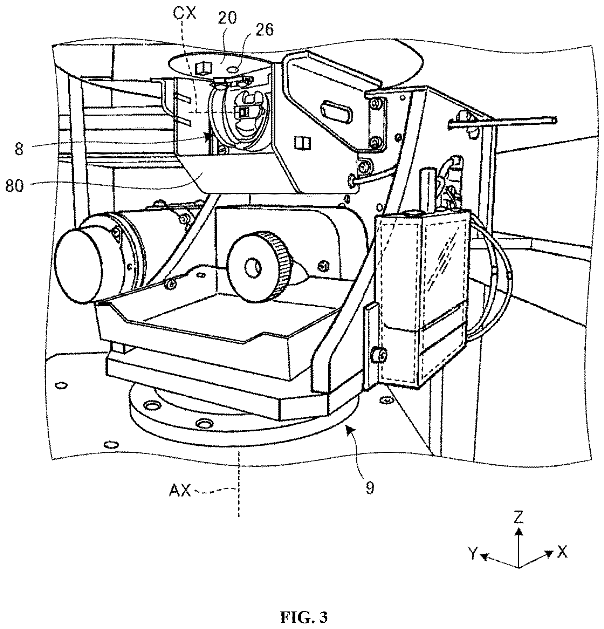

FIG. 1 is a perspective view showing a sewing machine 1 according to an embodiment. FIG. 2 and FIG. 3 are perspective views showing a part of the sewing machine 1 according to the embodiment. In the embodiment, the sewing machine 1 is an electronic cycle sewing machine. The sewing machine 1 includes a table 2, a frame 3, a head 4, a head rotary device 5, a holding member 6, a holding member moving device 7, a shuttle 8, a shuttle rotary device 9, a power switch 10, a start switch 11, a pause switch 12, an emergency stop switch 13 and an operation panel 14.

The table 2 includes a top plate 21 including a throat plate 20, legs 22, and side plates 23. The legs 22 support the top plate 21. A plurality of legs 22 are provided. Lower surfaces of the legs 22 contact a floor of a sewing factory. The side plates 23 are arranged between the plurality of legs 22.

An adjuster 24 is provided on each of the plurality of legs 22 respectively. The lower surfaces of the legs 22 moves in the Z-axis direction using the adjuster 24. The adjuster 24 is configured to adjust positions of the lower surfaces of the legs 22 in the Z-axis direction. That is, the adjuster 24 is configured to adjust heights of the lower surfaces of the legs 22. An inclination angle of an upper surface of the top plate 21 is adjusted by adjusting the height of each of the lower surfaces of the plurality of legs 22. In an embodiment, the height of each of the lower surfaces of the plurality of legs 22 is adjusted in a way that the upper surface of the top plate 21 is parallel to the XY plane.

The table 2 is movable on a floor using caster wheels 25. The caster wheels 25 include wheels or rollers. The caster wheels 25 movably support the table 2. The lower surfaces of the legs 22 may be off the floor using the adjuster 24. The table 2 is moved by the caster wheels 25 rotating on the floor while the lower surfaces of the legs 22 are off the floor. When the table 2 is arranged on the floor, the caster wheels 25 are off the floor by the adjuster 24 and the height of the lower surfaces of the legs 22 is adjusted in a way that the lower surfaces of the legs 22 contact with the floor.

The frame 3 is supported by the top plate 21 of the table 2. The frame 3 includes a first pillar 31 provided at a corner of the +X side and +Y side of the top plate 21, a second pillar 32 provided at a corner of the -X side and +Y side of the top plate 21 and a beam 30 connecting an upper end portion of the first pillar 31 and an upper end portion of the second pillar 32. The frame 3 is a so-called gate-shaped frame.

The head 4 is supported by the beam 30 of the frame 3. The head 4 is arranged above the holding member 6. The head 4 supports a needle bar 40. The head 4 is rotatable centered on a rotation axis AX perpendicular to the top surface of the top plate 21 while supporting the needle bar 40. In the embodiment, the rotation axis AX is substantially parallel to the Z axis. A cover member 33 is arranged around the head 4. The cover member 33 suppresses contact between the head 4 and objects around the cover member 33.

The needle bar 40 is supported by the head 4 in a way that the needle bar 40 is capable of moving back and forth in the Z-axis direction. The needle bar 40 holds a sewing machine needle 41. The needle bar 40 holds the sewing machine needle 41 in a way that the sewing machine needle 41 is parallel to the Z axis. In an embodiment, the rotation axis AX coincides with the sewing machine needle 41.

A thread winding device 16 is provided on the top plate 21. A thread stand device 17 is provided on the head 4. An upper thread is supplied from the thread winding device 16 to the sewing machine needle 41 via the thread stand device 17. The upper thread passes through a needle hole 42 of the sewing machine needle 41.

The head rotary device 5 generates power to rotate the head 4 centered on the rotation axis AX. The head rotary device 5 includes, for example, an electric actuator such as a stepping motor.

The holding member 6 holds a to-be-sewn article 50. The holding member 6 is a frame-shaped member. The holding member 6 holds the to-be-sewn article 50 by sandwiching a periphery of the to-be-sewn article 50. The holding member 6 is movably supported by the upper surface of the top plate 21. The holding member 6 holds the to-be-sewn article 50 to be movable on the upper surface of the top plate 21 including the sewing position directly below the sewing machine needle 41. The holding member 6 is movable within an XY plane parallel to the top surface of the top plate 21.

The holding member moving device 7 generates power to move the holding member 6 within the XY plane. The holding member moving device 7 is arranged on the upper surface of the top plate 21. The holding member moving device 7 includes an X-axis moving device 7X that moves the holding member 6 in the X-axis direction, and a Y-axis moving device 7Y that moves the holding member 6 in the Y-axis direction. The X-axis moving device 7X includes an X-axis guide member extending in the X-axis direction at the +Y side edge of the top plate 21 and an X-axis drive portion including an electric motor and a ball screw mechanism. The Y-axis moving device 7Y includes a Y-axis guide member extending in the Y-axis direction and a Y-axis drive portion including an electric motor and a ball screw mechanism.

The throat plate 20 is arranged below the needle bar 40. The throat plate 20 is fixed to the top plate 21. The throat plate 20 is arranged directly below the needle bar 40. The throat plate 20 includes an opening 26 through which the sewing machine needle 41 can pass.

The head 4 includes an intermediate presser foot 43 that presses the to-be-sewn article 50 from above. The intermediate presser foot 43 includes an opening through which the sewing machine needle 41 passes. The intermediate presser foot 43 presses the to-be-sewn article 50 around the sewing machine needle 41. The sewing machine needle 41 moves back and forth in the Z-axis direction. The intermediate presser foot 43 suppresses lifting of the to-be-sewn article 50 due to a movement of the sewing machine needle 41. The sewing machine needle 41 penetrates the to-be-sewn article 50 pressed by the intermediate presser foot 43.

The shuttle 8 is arranged below the throat plate 20. The shuttle 8 is arranged directly below the throat plate 20. A bobbin case is housed in the shuttle 8. The bobbin case holds a bobbin on which a lower thread is wound. The shuttle 8 cooperates with the sewing machine needle 41 to form seams on the to-be-sewn article 50 by supplying the lower thread.

The shuttle 8 is supported by a supporting member 80. The supporting member 80 is arranged to surround the shuttle 8.

The shuttle 8 rotates centered on a rotation axis CX as the sewing machine needle 41 moves back and forth. The rotation axis CX is substantially parallel to the XY plane. When the sewing machine needle 41 that penetrates the to-be-sewn article 50 rises, a loop of the upper thread is formed. The loop of the upper thread is hung on a tip of the shuttle 8 that rotates. The loop of the upper thread hung on the tip expands as the shuttle 8 rotates and passes through the surface of the bobbin case. When the loop of the upper thread comes off the tip, the upper thread is drawn to the to-be-sewn article 50 and intertwined with the lower thread. A seam is formed on the to-be-sewn article 50 by intertwining the upper thread and the lower thread.

The shuttle 8 rotates centered on a rotation axis AX in synchronization with the head 4. That is, the head 4 and the shuttle 8 rotate together centered on the rotation axis AX. The shuttle 8 and the supporting member 80 rotate together centered on the rotation axis AX. A relative position of the shuttle 8 and the supporting member 80 are constant.

The shuttle rotary device 9 generates power to rotate the shuttle 8 centered on rotation axis AX. The shuttle rotary device 9 includes, for example, an electric actuator such as a stepping motor. The shuttle rotary device 9 drives the head 4 and the shuttle 8 so that they rotate together centered on rotation axis AX.

Each of the power switch 10, the start switch 11, the pause switch 12, the emergency stop switch 13 and the operation panel 14 is operated by an operator. The power source of the sewing machine 1 is started by operating the power switch 10. Driving of the sewing machine 1 is started by the start switch 11 operating, and a sewing process is started by the sewing machine 1. The sewing process refers to a process of forming seams on the to-be-sewn article 50. The sewing machine 1 forms seams on the to-be-sewn article 50 based on sewing data created in advance. The seams are formed on the to-be-sewn article 50 by moving the holding member 6 in the XY plane including the sewing position based on the sewing data while holding the to-be-sewn article 50. The driving of the sewing machine 1 is stopped by operating the pause switch 12. The driving of the sewing machine 1 is forcibly stopped by operating the emergency stop switch 13.

The operation panel 14 is mounted on the top surface of the top plate 21. The operation panel 14 displays various information regarding the sewing machine 1 and receives various information regarding the operation of the sewing machine 1. The operation panel 14 includes an input device 18 and a display device 19. The input device 18 is implemented by a touch screen that specifies input positions and coordinates on the display surface of the display device 19. The display device 19 is implemented by a display apparatus such as a liquid crystal display or an organic EL display. In the present embodiment, a case in which the operation panel 14 is an example of an output portion that outputs various information will be described, but the operation panel 14 is not limited thereto. The operation panel 14 may be mounted on the head 4 or the table 2.

### Functional structure of the sewing machine

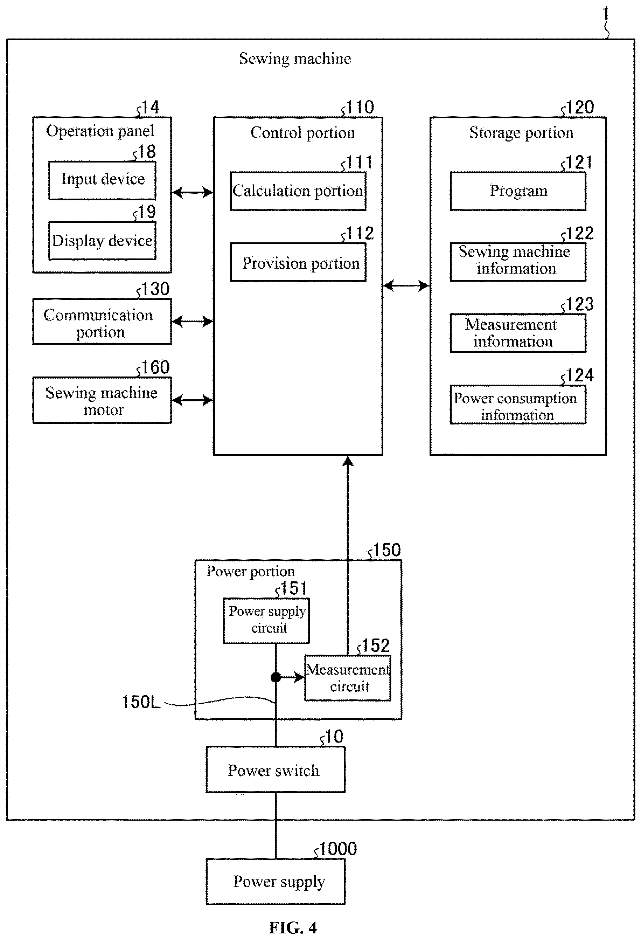

FIG. 4 is a block diagram showing an example of a functional structure of a sewing machine 1 according to an embodiment. As shown in FIG. 4, the sewing machine 1 includes a control portion 110, a storage portion 120 connected to the control portion 110, a communication portion 130, the aforementioned operation panel 14, a power portion 150 and a sewing machine motor 160. The control portion 110 is composed of central computing units such as a central processing unit (CPU). The storage portion 120 stores programs executed by the control portion 110 and functions as a work area for the control portion 110. The control portion 110 controls the functional portions of the sewing machine 1 according to data and instructions, thereby realizing various functions. The functional portions include, for example, the operation panel 14, the communication portion 130, and the sewing machine motor 160, but are not limited thereto.

The storage portion 120 can store a program 121, various information such as sewing machine information 122, measurement information 123 and power consumption information 124. The program 121 are programs that causes the control portion 110 to execute functions for realizing processes related to various operations of the sewing machine 1. The sewing machine information 122 includes information such as a sewing machine ID assigned to the sewing machine 1. The measurement information 123 includes information indicating current and voltage of a power supply line 150L of the power portion 150. The power consumption information 124 includes information indicating power consumption based on the current and the voltage of the power supply line 150L.

The communication portion 130 communicates, for example, with other communication apparatuses. The communication portion 130 can support various communication standards. The communication portion 130, for example, transmits and receives various information via a wired network or wireless network. The communication portion 130 supplies received information to the control portion 110. The communication portion 130 transmits information to a destination specified by the control portion 110.

The operation panel 14 includes an input device 18 and a display device 19. The input device 18 receives input from an operator or the like, and supplies the input information to the control portion 110. The display device 19 displays various information such as power consumption information 124 under the control of the control portion 110.

The power portion 150 supplies power obtained from an external power supply 1000 to each functional portion of the sewing machine 1 including the control portion 110 and the storage portion 120 via the power supply line 150L. The functional portions include, for example, a communication portion 130, an operation panel 14, a sewing machine motor 160, and the like. The power portion 150 supplies power from the power supply 1000 via the power supply line 150L when the power switch 10 is turned on. The power portion 150 cuts off power supply from the power supply 1000 via the power supply line 150L when the power switch 10 is turned off.

The power portion 150 includes a power supply circuit 151 and a measurement circuit 152. The power supply circuit 151 is electrically connected to the power supply line 150L, and supplies power from the power supply 1000 via the power supply line 150L. The power supply circuit 151 supplies power from power supply 1000 to the control portion 110, the storage portion 120, various functional portion, etc. of the sewing machine 1. The measurement circuit 152 is a circuit including a current sensor that measures a current flowing through the power supply line 150L and a voltage sensor that measures a voltage of the power supply line 150L. The measurement circuit 152 is electrically connected to the control portion 110 and supplies measurement information 123 indicating the measured current and voltage to the control portion 110. In the present embodiment, a case in which the measurement circuit 152 measures the current and the voltage of the power supply line 150L will be described, but the measurement circuit 152 is not limited thereto. For example, the measurement circuit 152 may be a structure that measures a current and a voltage of the supply system that is supplied to the sewing machine motor 160.

The sewing machine motor 160 is a drive source for various mechanisms of the sewing machine 1. The sewing machine motor 160 includes, for example, a stepping motor, a servo motor, and the like. The sewing machine motor 160 generates power for a reciprocating mechanism of the sewing machine needle 41 using electric power from the power portion 150. The operation of the sewing machine motor 160 is controlled by the control portion 110. The sewing machine motor 160 includes motors such as the head rotary device 5, the holding member moving device 7 and the shuttle rotary device 9 described above.

The control portion 110 is a computer that controls functional portions that operate using the power supplied from the power portion 150. The control portion 110 includes a calculation portion 111 and a provision portion 112. The control portion 110 realizes the functions of the calculation portion 111 and the provision portion 112 by executing the program 121. The program 121 is a program for causing the control portion 110 of the sewing machine 1 to function as the calculation portion 111 and the provision portion 112. The control portion 110 realizes or executes information processing functions and operations described below.

The calculation portion 111 calculates the power consumption information 124 of the sewing machine 1 based on the current and the voltage measured by the measurement circuit 152. The calculation portion 111 calculates the power consumption (W) by multiplying a current value (A) and a voltage value (V) indicated by the measurement information 123 from the measurement circuit 152. Since the control portion 110 controls the operation of the sewing machine motor 160, the calculation portion 111 can detect timing of the operation of the sewing machine motor 160. In the sewing machine 1, whether the sewing machine motor 160 is operating can be determined based on an increase or a decrease in a power value indicated by the power consumption information 124, and an operating rate can be obtained from a result of the determination. Therefore, the calculation portion 111 calculates the power consumption information 124 so that the increase or the decrease in the power consumption of the sewing machine motor 160 can be identified. The power consumption information 124 includes, for example, information that allows identification of power per predetermined time.

The calculation portion 111 obtains, from measurement circuit 152, measurement information 123 at a timing corresponding to operating time of the sewing machine motor 160 so that it can identify increases, decreases, changes, etc. in power consumption and calculate the power consumption of the sewing machine motor 160 based on the measurement information 123. The timing corresponding to the operation time of the sewing machine motor 160 is, for example, an arbitrary timing between the control portion 110 starts the operation of the sewing machine motor 160 and the end of the operation, a timing when the sewing machine motor 160 starts and ends, a timing when the sewing machine motor 160 is not operating, a timing set on the operation panel 14, etc. The calculation portion 111 stores power consumption information 124 indicating calculated power consumption in the storage portion 120 in a timing order.

The provision portion 112 provides the power consumption information 124 calculated by the calculating portion 111. The provision portion 112 has a function of providing one or more pieces of power consumption information 124 stored in the storage portion 120 to a host system, a database, or the like. The provision portion 112 has a function of providing one or more pieces of power consumption information 124 stored in the storage portion 120 in a way of being displayed (output) on the operation panel 14, which is an output portion. The provision portion 112 may provide the power consumption information 124 calculated by the calculating portion 111 at any time, or may provide a plurality of power consumption information 124 at once.

Examples of the functional structure of the sewing machine 1 according to the present embodiment has been described above. In addition, the above structure described using FIG. 4 is just an example, and the functional structure of the sewing machine 1 according to the present embodiment is not limited to the embodiments. The functional structure of the sewing machine 1 according to the present embodiment can be flexibly modified according to specifications and application.

### Processing procedures of the sewing machine

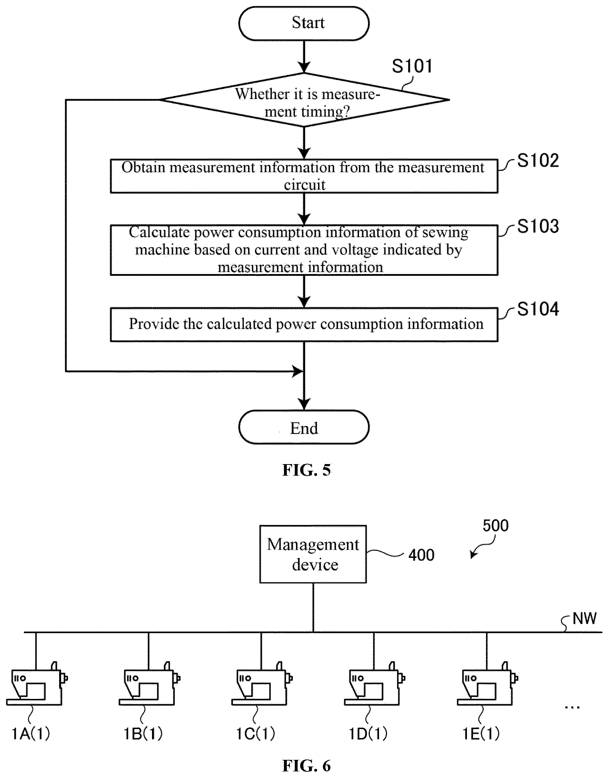

Next, an example of the processing procedures of the sewing machine 1 will be explained. FIG. 5 is a flowchart showing an example of a processing procedure of a sewing machine 1. The processing procedure shown in FIG. 5 is realized by the control portion 110 of the sewing machine 1 executing the program 121. The processing procedures shown in FIG. 5 are repeatedly performed by the control portion 110.

As shown in FIG. 5, the control portion 110 of the sewing machine 1 determines whether it is measurement timing (step S101). The measurement timing includes, for example, a timing when the sewing machine motor 160 is operating or stopped, a timing when the state of the sewing machine 1 changes, a preset timing when power consumption is measured, and the like. For example, when a control result of the sewing machine 1 is determined to be consistent with the measurement timing, the control portion 110 determines that the timing is the measurement timing. When the control portion 110 determines that it is not the measurement timing (in step S101), the control portion 110 ends the processing procedure shown in FIG. 5 without performing the measurement.

Further, when the control portion 110 determines that it is the measurement timing (Yes in step S101), the control portion 110 proceeds the process to step S102. The control portion 110 obtains measurement information 123 from the measurement circuit 152 (step S102). For example, the control portion 110 obtains measurement information 123 indicating the current and the voltage measured by the measurement circuit 152, and stores the obtained measurement information 123 in the storage portion 120 in a timing order. When the process of step S102 ends, the control portion 110 proceeds the process to step S103.

The control portion 110 calculates the power consumption information 124 of the sewing machine 1 based on the current and the voltage indicated by measurement information 123 (step S103). The control portion 110 calculates the power consumption information 124 indicating a power consumption value by multiplying the current and the voltage indicated by the measurement information 123, and associates the sewing machine ID of the sewing machine 1, the measurement timing, information that can identify the state of the sewing machine 1, etc. and stores them in the storage portion 120. When the process of step S103 ends, the control portion 110 proceeds to step S104.

The control portion 110 provides the calculated power consumption information 124 (step S104). For example, the control portion 110 provides the power consumption information 124 to the host system by transmitting the power consumption information calculated in step S103 to the host system via the communication portion 130. Thereby, the host system refers to the power consumption information 124 and control the power consumption of the sewing machine 1. Further, the control portion 110 provides the power consumption information 124 to the operator of the sewing machine 1 by controlling the operation panel 14 to output (display) the power consumption information 124 calculated in step S103. When step S104 ends, the control portion 110 ends the processing procedure shown in FIG. 5.

Traditional sewing machines have no power consumption measurement function since adding a power measurement mechanism to the structure would increase costs. In traditional sewing machines, if power consumption is expected to be measured, an external power meter is required, which is difficult to implement a power consumption measurement function. Some traditional sewing machines use internal current and voltage values for control, but do not have a power consumption measurement function. In contrast, in the sewing machine 1 according to the embodiment, the control portion 110 calculates the power consumption information 124 using the current and the voltage measured in the power supply line 150L of the power portion 150, and can provide the power consumption information 124. Thereby, it is not necessary to add a power measurement mechanism or the like to the sewing machine 1, and an increase in the cost of the sewing machine 1 can be suppressed and the power consumption can be controlled.

### Management system for sewing machine

An example of a management system for a sewing machine that manages the sewing machine 1 described above will be described. FIG. 6 is a structural diagram of a management system for a sewing machine. As shown in FIG. 6, the management system for a sewing machine 500 includes a plurality of the sewing machines 1 described above and a management device 400 that manages the plurality of the sewing machines 1. The plurality of the sewing machines 1 and the management device 400 are configured to communicate via the network NW. The sewing machines 1A, 1B, 1C, 1D and 1E have the same configuration as the sewing machine 1 described above. In the example shown in FIG. 6, five sewing machines 1: sewing machine 1A, sewing machine 1B, sewing machine 1C, sewing machine 1D, and sewing machine 1E are shown. When explaining the common contents of these sewing machines, "sewing machine 1" will be used and duplicate explanations will be omitted.

### Management device

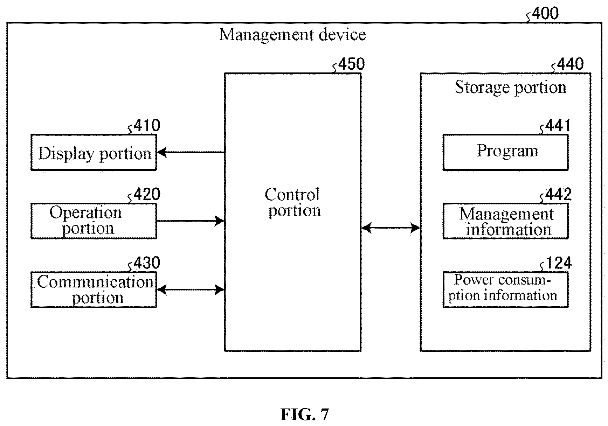

The management device 400 is, for example, a computer, a server device, or the like. FIG. 7 is a diagram showing an example of a structure of a management device. As shown in FIG. 7, the management device 400 includes a display portion 410, an operation portion 420, a communication portion 430, a storage portion 440 and a control portion 450. The control portion 450 is electrically connected to the display portion 410, the operation portion 420, the communication portion 430, the storage portion 440, and the like.

The display portion 410 is configured to display various information under the control of the control portion 450. The display portion 410 includes, for example, a display panel such as a liquid crystal display or an organic EL display. The display portion 410 displays various information based on signals input from the control portion 250.

The operation portion 420 includes one or more devices for receiving user operations. The devices for receiving user operations include, for example, keys, buttons, touch screens, mice, and the like. The operation portion 420 can supply a signal corresponding to a received operation to the control portion 450.

The communication portion 430 can communicate with, for example, the sewing machine 1 and other communication devices. The communication portion 430 can support various communication standards. The communication portion 430 transmits and receives various information via, for example, a wired or wireless network NV. The communication portion 430 can supply the received information to the control portion 450. The communication portion 430 transmits the information to a destination specified by the control portion 450.

The storage portion 440 can store programs and data. The storage portion 440 is also used as a work area to temporarily store processing results of the control portion. The storage portion 440 can store various information such as the program 241, management information 442, and the above-mentioned power consumption information 124. The program 441 causes the control portion 450 to execute functions such as managing the plurality of the sewing machines 1. The management information 442 includes information such as power consumption, an operating state, and an operating rate of the plurality of the sewing machines 1. The power consumption information 124 is obtained from a plurality of the sewing machines 1, and is stored for each of the plurality of the sewing machines 1.

The control portion 450 is an arithmetic processing device. The control portion 450 can execute instructions included in the program 441 stored in the storage portion 440 while referring to information stored in the storage portion 440 as necessary. The control portion 450 controls the configuration of the sewing machine 1 according to the data and instructions, thereby realizing various functions.

By executing the program 441, the control portion 450 can provide a function of managing the operating state of each of the plurality of the sewing machines 1 based on the power consumption information 124 provided by the sewing machines 1. The control portion 450 manages power consumption and productivity of functional portions of the sewing machine 1 based on the power consumption information 124 of the sewing machine 1. The control portion 450 realizes visualization of the sewing machine power in management system for a sewing machine 500 by managing power consumption for each of the sewing machines 1A, 1B, 1C, 1D and 1E. The control portion 450 determines whether the sewing machine motor 160 is operating based on the power consumption information 124 as well as an increase or a decrease in the value of power consumption. The control portion 450 calculates an operating rate of the sewing machine 1 based on the operating time in a determination result, and manages the operating state of the sewing machine 1.

Examples of the functional structure of the management device 400 according to the present embodiment has been described above. Further, above structure described using FIG. 3 is just an example, and the functional structure of the management device 400 according to the present embodiment is not limited to the example. The functional structure of the management device 400 according to the present embodiment can be flexibly modified according to specifications and application.

### Example of operation of management system for a sewing machine

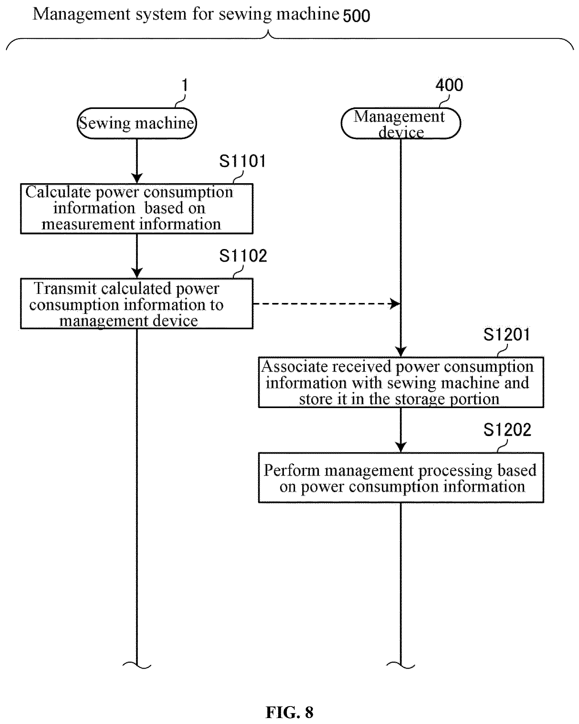

Next, an example of the operation of the sewing machine 1 and the management device 400 in the management system for a sewing machine 500 will be described. FIG. 8 is a diagram showing an example of operating of the sewing machine 1 and the management device 400. In FIG. 8, only one sewing machine 1 is shown to simplify the explanation.

As shown in FIG. 8, the sewing machine 1 calculates the power consumption information 124 based on the measurement information 123 (step S1101). Sewing machine 1 transmits the calculated power consumption information 124 to the management device 400 via the communication portion 130 (step S1102).

The management device 400 associates the received power consumption information 124 with the sewing machine 1 and store it in the storage portion 440 (step S1201). For example, the management device 400 identifies the sewing machine 1 that transmitted the power consumption information 124, associates the received power consumption information 124 with the identified sewing machine 1 and stores it in the storage portion 440. Further, the management device 400 executes management process based on the power consumption information 124. The management processing includes, for example, a processing that manages the power consumption and productivity of functional portions of the sewing machine 1 based on the power consumption information 124 of the sewing machine 1, a processing that manages the operating state of the sewing machine 1, and a processing that displays the power consumption of each of the plurality of the sewing machines on the display portion 410, etc. Thereafter, the sewing machine 1 and the management device 400 perform similar processing.

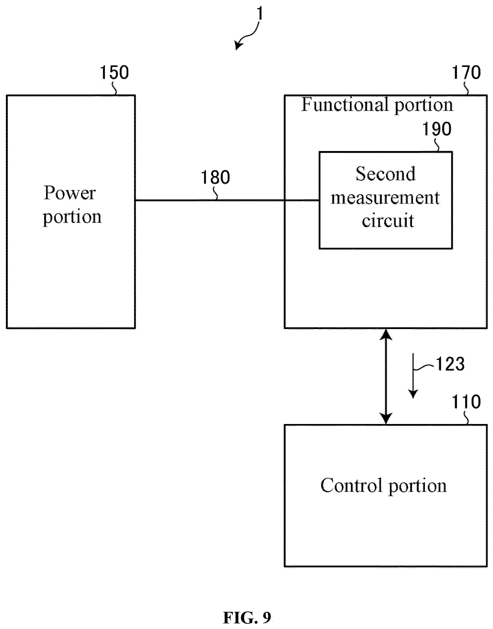

According to the invention, the sewing machine 1 described above includes a plurality of functional portions, the functional portions can be modularized. FIG. 9 is a diagram for illustrating a functional structure of a sewing machine according to the invention. In FIG. 9, the sewing machine 1 includes the above-mentioned control portion 110, a power portion 150, and a functional portion 170. In addition, in FIG. 9, in order to simplify the explanation, in the sewing machine 1, only the configurations of the power portion 150 and the functional portion 170 are described, and other configurations are omitted.

The functional portion 170 is a modular functional structure of the sewing machine 1. The functional portion 170 is, for example, a structure including a substrate that operates with power supplied from the power portion 150 via the supply line 180. The functional portion 170 is electrically connected to the control portion 110 and realizes functions under the control of the control portion 110. The sewing machine 1 includes a second measurement circuit 190 in the functional portion 170. The second measurement circuit 190 is a circuit including a current sensor that measures a current flowing through the supply line 180 and a voltage sensor that measures a voltage of the supply line 180. The second measurement circuit 190 supplies the control portion 110 with measurement information 123 that indicates the current and the voltage measured on the supply line 180 and allows identification of the functional portion 170.

The control portion 110 associates the measurement information 123 from the second measurement circuit with the functional portion 170 corresponding to the second measurement circuit and stores it in the storage portion 120. The calculation portion 111 of the control portion 110 calculates the power consumption information 124 of the functional portion 170 based on a current and a voltage of the measurement information 123. That is, the control portion 110 according to an embodiment may calculate the power consumption information 124 of the entire sewing machine 1 and the functional portion 170. In the sewing machine 1 including a plurality of functional portions 170, the control portion 110 calculates the power consumption information 124 for each of the plurality of functional portions 170. Further, a provision portion 112 of the control portion 110 provides power consumption information 124 capable of identifying the power consumption of the entire sewing machine 1 and the functional portion 170.

Thereby, the sewing machine 1 may calculate the power consumption information 124 of the functional portion 170 and provide the power consumption information 124, which can visualize the power consumption of the functional portion 170 and increases an added value of the sewing machine 1. Furthermore, the sewing machine 1 can visualize power and productivity in the sewing machine 1 by providing the power consumption information 124 of the plurality of functional portions 170.

### Effects

As described above, the control portion 110 of the sewing machine 1 may calculate the power consumption information 124 using the current and the voltage measured in the power supply line 150L of the power portion 150, and provides the power consumption information 124. As a result, the sewing machine 1 only needs to use the current and the voltage measured in the power supply line 150L of the power portion 150, and there is no need to add a structure for measuring power consumption, and an increase in the cost of the sewing machine 1 can be suppressed and the power consumption can be controlled.

The sewing machine 1 may calculate power consumption information 124 including the power consumption of the sewing machine motor 160. As a result, the sewing machine 1 may determine whether the sewing machine motor 160 is operating based on the power consumption information 124, thereby improving the convenience of the power consumption information 124 suitable for managing the sewing machine 1.

The sewing machine 1 may calculate power consumption information by obtaining current and voltage corresponding to the operating time of the sewing machine motor 160. Thereby, the sewing machine 1 can provide power consumption information 124 corresponding to the operation of the sewing machine motor 160, so that the power consumption of the sewing machine motor 160 can be visualized.

The sewing machine 1 can provide the power consumption information 124 in a way of outputting from the operation panel 14 (output portion). Thereby, the sewing machine 1 can make the user using the sewing machine 1 identify the power consumption, thereby contributing to suppressing power consumption.

The sewing machine 1 may calculate the power consumption information 124 in the supply line 180 of the functional portion 170 and provide the power consumption information 124. As a result, the sewing machine 1 can visualize the power consumption of the functional portion 170, thereby increasing the added value to the sewing machine 1. Furthermore, the sewing machine 1 can visualize power and productivity in the sewing machine 1 by providing the power consumption information 124 of the plurality of functional portions 170.

The control portion 110 of the management system for a sewing machine 500 may calculate the power consumption information 124 using the current and the voltage measured by the sewing machine 1 in the power supply line 150L of the power portion 150, and provide the power consumption information 124. The management device 400 of the management system for the sewing machine 500 can manage the operating state of each of the plurality of the sewing machines 1 based on the power consumption information 124 of the sewing machines 1. As a result, the management system for the sewing machine 500 only needs to use the current and the voltage measured by the sewing machine 1 in the power supply line 150L of the power portion 150, there is no need to add a configuration for measuring power consumption, and an increase in the cost of the sewing machine 1 can be suppressed and the power consumption of the sewing machine 1 can be managed.

## Claims

1. A sewing machine, comprising:
a power portion (150), configured to supply power from a power supply line (150L) to functional portions (170) of the sewing machine including for example an operation panel (14), a sewing machine motor (160) or a communication portion (130); and
a control portion (110), configured to control the functional portions (170) to operate using the power supplied from the power portion (150),
wherein the power portion (150) comprises a measurement circuit (152) for measuring current and voltage in the power supply line (150L), and
the control portion (110) comprises:
a calculation portion (111), configured to calculate power consumption information of the sewing machine (1) based on the current and the voltage measured by the measurement circuit (152); and
a provision portion (112), configured to provide the calculated power consumption information;
**characterized in that** a functional portion (170) further comprises:
a second measurement circuit (190) comprising a current sensor and a voltage sensor, configured to measure current and voltage in a supply line (180) for supplying power from the power portion (150) to the functional portion (170) and supply the control portion (110) , to which the functional portion is electrically connected, with measurement information (123) indicating the current and the voltage measured on the supply line (180) and identifying the functional portion (170), wherein the control portion (110) associates the measurement information (123) with the functional portion (170) and stores it in a storage portion (120).

2. The sewing machine according to claim 1, wherein
the functional portion (170) comprises a sewing machine motor (160); and
the calculation portion (111) calculates the power consumption information comprising power consumption of the sewing machine motor (160).

3. The sewing machine according to claim 2, wherein
the calculation portion (111) obtains a current and a voltage corresponding to operating time of the sewing machine motor (160) to calculate the power consumption information.

4. The sewing machine according to claim 3, wherein
the provision portion (112) provides the power consumption information in a way of outputting through an output portion.

5. The sewing machine according to claim 4,
wherein the calculation portion (111) of the control portion (110) calculates power consumption information of the functional portion (170) based on the current and the voltage measured from the second measurement circuit (190).

6. A management system for a sewing machine, comprising:
a sewing machine (1) of claim 1; and
a management device for managing the sewing machine,
wherein the management device manages an operating state of the sewing machine (1) based on the power consumption information provided by the sewing machine (1).

## Patentansprüche

1. Eine Nähmaschine, umfassend:
einen Energieabschnitt (150), der dazu konfiguriert ist, Energie von einer Energieversorgungsleitung (150L) an Funktionsabschnitte (170) der Nähmaschine, wie beispielsweise ein Bedienpanel (14), einen Nähmaschinenmotor (160) oder einen Kommunikationsabschnitt (130), zu liefern; und
einen Steuerabschnitt (110), der dazu konfiguriert ist, die Funktionsabschnitte (170) zu steuern, um unter Verwendung der von dem Energieabschnitt (150) zugeführten Energie zu arbeiten,
wobei der Energieabschnitt (150) eine Messschaltung (152) zum Messen von Strom und Spannung in der Energieversorgungsleitung (150L) umfasst, und
der Steuerabschnitt (110) umfasst:
einen Berechnungsabschnitt (111), der dazu konfiguriert ist, Stromverbrauchsinformationen der Nähmaschine (1) auf der Grundlage des von der Messschaltung (152) gemessen Stroms und der von der Messschaltung (152) gemessenen Spannung zu berechnen; und
einen Bereitstellungsabschnitt (112), der dazu konfiguriert ist, die berechneten Stromverbrauchsinformationen bereitzustellen;
**dadurch gekennzeichnet, dass** ein Funktionsabschnitt (170) ferner umfasst:
eine zweite Messschaltung (190), die einen Stromsensor und einen Spannungssensor umfasst und dazu konfiguriert ist, den Strom und die Spannung in einer Versorgungsleitung (180) zum Liefern von Energie von dem Energieabschnitt (150) zu dem Funktionsabschnitt (170) zu messen, und den Steuerabschnitt (110), mit welchem der Energieabschnitt elektrisch verbunden ist, mit Messinformationen (123) zu versorgen, die den in der Versorgungsleitung (180) gemessenen Strom und die in der Versorgungsleitung (180) gemessene Spannung angeben und den Funktionsabschnitt (170) identifizieren, wobei der Steuerabschnitt (110) die Messinformationen (123) dem Funktionsabschnitt (170) zuordnet und in einem Speicherabschnitt (120) speichert.

2. Nähmaschine nach Anspruch 1, wobei
der Funktionsabschnitt (170) einen Nähmaschinenmotor (160) umfasst; und
der Berechnungsabschnitt (111) die Stromverbrauchsinformation berechnet, die einen Stromverbrauch des Nähmaschinenmotors (160) umfasst.

3. Nähmaschine nach Anspruch 2, wobei
der Berechnungsabschnitt (111) einen Strom und eine Spannung entsprechend der Betriebszeit des Nähmaschinenmotors (160) erhält, um die Energieverbrauchsinformation zu berechnen.

4. Nähmaschine nach Anspruch 3, wobei
der Bereitstellungsabschnitt (112) die Stromverbrauchsinformationen in einer Weise der Ausgabe durch einen Ausgabeabschnitt ausgibt.

5. Nähmaschine nach Anspruch 4,
wobei der Berechnungsabschnitt (111) des Steuerabschnitts (110) die Energieverbrauchsinformationen des Funktionsabschnitts (170) auf der Grundlage des von der zweiten Messschaltung (190) gemessen Stroms und der von der zweiten Messschaltung (190) gemessen Spannung berechnet.

6. Managementsystem für eine Nähmaschine, umfassend:
eine Nähmaschine (1) nach Anspruch 1; und
eine Managementvorrichtung zum Managen der Nähmaschine,
wobei die Managementvorrichtung einen Betriebszustand der Nähmaschine (1) auf der Grundlage der von der Nähmaschine (1) gelieferten Informationen über den Stromverbrauch managt.

## Revendications

1. Machine à coudre, comportant :
une partie (150) d'alimentation, configurée pour fournir une alimentation provenant d'une ligne (150L) d'alimentation électrique à des parties fonctionnelles (170) de la machine à coudre, y compris par exemple un tableau (14) de commande, un moteur (160) de machine à coudre ou une partie (130) de communication ; et
une partie (110) de commande, configurée pour commander les parties fonctionnelles (170) pour qu'elles fonctionnent en utilisant l'alimentation fournie en provenance de la partie (150) d'alimentation,
la partie (150) d'alimentation comportant un circuit (152) de mesure servant à mesurer un courant et une tension dans la ligne (150L) d'alimentation électrique, et
la partie (110) de commande comportant :
une partie (111) de calcul, configurée pour calculer des informations de consommation d'énergie de la machine (1) à coudre d'après le courant et la tension mesurés par le circuit (152) de mesure ; et
une partie (112) de fourniture, configurée pour fournir les informations calculées de consommation d'énergie ;
**caractérisée en ce qu'**une partie fonctionnelle (170) comporte en outre :
un second circuit (190) de mesure comportant un capteur de courant et un capteur de tension, configurés pour mesurer un courant et une tension dans une ligne (180) d'alimentation servant à fournir une alimentation provenant de la partie (150) d'alimentation à la partie fonctionnelle (170) et à fournir à la partie (110) de commande, à laquelle la partie fonctionnelle est reliée électriquement, des informations (123) de mesure indiquant le courant et la tension mesurés sur la ligne (180) d'alimentation et identifiant la partie fonctionnelle (170), la partie (110) de commande associant les informations (123) de mesure à la partie fonctionnelle (170) et les stockant dans une partie (120) de stockage.

2. Machine à coudre selon la revendication 1,
la partie fonctionnelle (170) comportant un moteur (160) de machine à coudre ; et
la partie (111) de calcul calculant les informations de consommation d'énergie qui comprennent une consommation d'énergie du moteur (160) de machine à coudre.

3. Machine à coudre selon la revendication 2,
la partie (111) de calcul obtenant un courant et une tension correspondant à un temps de fonctionnement du moteur (160) de machine à coudre pour calculer les informations de consommation d'énergie.

4. Machine à coudre selon la revendication 3,
la partie (112) de fourniture fournissant les informations de consommation d'énergie au moyen d'une sortie à travers une partie de sortie.

5. Machine à coudre selon la revendication 4,
la partie (111) de calcul de la partie (110) de commande calculant des informations de consommation d'énergie de la partie fonctionnelle (170) d'après le courant et la tension mesurés à partir du second circuit (190) de mesure.

6. Système de gestion pour machine à coudre, comportant :
une machine (1) à coudre selon la revendication 1 ; et
un dispositif de gestion servant à gérer la machine à coudre,
le dispositif de gestion gérant un état de fonctionnement de la machine (1) à coudre d'après les informations de consommation d'énergie fournies par la machine (1) à coudre.
